# EUROPÄISCHE PATENTSCHRIFT

(11) **EP 1 459 110 B1**
(45) Veröffentlichungstag und Bekanntmachung des Hinweises auf die Patenterteilung: **27.04.2005**
(21) Anmeldenummer: 02787915.4
(22) Anmeldetag: 06.12.2002
(51) Int. Cl.: G02B 5/00, G02B 5/02, G02B 26/00, G02B 3/00, C08K 3/00, C08K 3/04, C08K 3/08, C08K 3/22, C08K 5/00

(54) **KOMPOSITMASKE ZUR HERSTELLUNG EINES DIFFUSORS**
COMPOSITE MASK FOR PRODUCING A DIFFUSER
MASQUE COMPOSITE CONCU POUR PRODUIRE UN DIFFUSEUR

(30) Priorität: 13.12.2001 DE 10161200
(43) Veröffentlichungstag der Anmeldung: 22.09.2004
(73) Patentinhaber: Clariant GmbH, 65929 Frankfurt am Main (DE)
(72) Erfinder: HARADA, Takamasa, Chiba 270-13 (JP); KITA, Fumio, 65187 Wiesbaden (DE); ZIMMERMANN, Andreas, 64347 Griesheim (DE); ALTHERR, Andreas, 66583 Spiesen-Elversberg (DE); MENNIG, Martin, 66287 Quierschied (DE); OLIVEIRA, Peter, W., 66111 Saarbrücken (DE); SCHMIDT, Helmut, 66130 Saarbrücken-Güdigen (DE)
(74) Vertreter: Hütter, Klaus, Dr.
(86) Internationale Anmeldenummer: PCT/EP2002/013846
(87) Internationale Veröffentlichungsnummer: WO 2003/050574

(56) Entgegenhaltungen:
- EP-A- 0 437 902
- EP-A- 0 671 638
- WO-A-01/22130
- WO-A-03/005072
- US-A- 5 695 895
- US-A- 5 714 247
- US-A- 5 876 857
- US-A- 5 900 309
- US-B1- 6 280 835

## Beschreibung

Die vorliegende Erfindung beschreibt eine Alternative zu bislang verwendeten Photomasken zur Herstellung von Diffusorfolien.

Nach der WO 94/29768 oder EP-A-0 671 638 werden Diffusorfolien hergestellt, indem man ein lichtempfindliches, transparentes Material (Photopolymer, Photo-Nanomer) auf eine photographische Platte (Maske) laminiert und durch diese hindurch mit konvergenter UV-Strahlung belichtet. Das Photopolymer bzw. das Photo-Nanomer enthält Monomere bzw. nanoskalige Teilchen, die von benachbarten unbestrahlten Bereichen in bestrahlte Bereiche des lichtempfindlichen, transparenten Materials diffundieren. Derartige Materialien sind beispielsweise in der WO 97/38333 beschrieben. Die Maske selbst besteht dabei aus Photogelatine auf einer Glasschicht und wurde zuvor über einen komplizierten Laserschreibprozess mit anschließender nasschemischer Entwicklung und Fixierung (Technik der Schwarz-Weiß-Photographie) hergestellt. Dieses Verfahren ist sehr zeit- und kostenaufwendig. Der Schreibprozess und die nachfolgende Weiterverarbeitung sind anfällig für Fehler (Punktdefekte), die sich ins Endprodukt (Diffusor) fortpflanzen. Das Maskenmaterial (Gelatine) ist mechanisch und chemisch sehr empfindlich, was die Lebensdauer der Maske begrenzt. Das technisch maximal mögliche Maskenformat beträgt derzeit etwa nur 30 cm x 40 cm und es stehen keine Endlosmasken zur Verfügung, was die Weiterverarbeitung der Diffuser zu großflächigen Displayfolien behindert.

Der Erfindung lag daher die Aufgabe zugrunde, eine kostengünstige Alternative zu Photomasken zu finden, die ohne großen technischen Aufwand auf größere Breiten (z.B. 0,60 m oder 1,20 m) aufskaliert werden können und endlos sind.

Die Aufgabe wurde durch eine neuartige Kompositmaske gelöst, die aus einem feinkörnigen, Licht absorbierenden Pigment oder feinkörnigen Metallpartikeln in einer transparenten Matrix, die als dünner Film auf einer transparenten Kunststofffolie aufgetragen ist, besteht.

Gegenstand der Erfindung ist daher eine Kompositmaske, bestehend im wesentlichen aus einer transparenten Trägerfolie, die mit einer transparenten Polymermatrix und darin enthaltenden lichtabsorbierenden Pigmentteilchen oder Metallpartikel mit einer mittleren Teilchengröße d₅₀ zwischen 0,5 und 10 µm, vorzugsweise zwischen 1 und 5 µm, besonders bevorzugt zwischen 2 und 4 µm, beschichtet ist.

Als Pigmente eignen sich alle fein-pulvrigen Materialien, die für das zur Diffuserherstellung verwendete Licht, vorzugsweise UV/Vis-Licht einer Wellenlänge von 190 bis 500 nm, nicht durchlässig sind. Die Partikelgröße des Pigmentes richtet sich nach der herzustellenden Maskenstruktur.

Als Pigmente eignen sich anorganische und organische Pigmente in der genannten Teilchengröße.
Als organische Pigmente kommen beispielsweise Monoazo-, Disazo-, verlackte Azo-, β-Naphthol-, Naphthol AS-, Benzimidazolon-, Disazokondensations-, Azo-Metallkomplex-Pigmente und polycyclische Pigmente wie zum Beispiel Phthalocyanin-, Chinacridon-, Perylen-, Perinon-, Thiazinindigo-, Thioindigo-, Anthanthron-, Anthrachinon-, Flavanthron-, Indanthron-, Isoviolanthron-, Pyranthron-, Dioxazin-, Chinophtalon-, Isoindolinon-, Isoindolin- und Diketopyrrolopyrrol-Pigmente oder Carbon Black-Pigmente (Ruße) oder Graphit in Betracht.

Als anorganische Pigmente kommen beispielsweise
Metalloxide, wie z.B. Antimonoxid, Bismutoxid, Bleioxid, Cadmiumoxid, Chromoxide, Cobaltoxid, Eisenoxide, Indiumoxide, Kupferoxide, Manganoxide, Nickeloxid, Quecksilberoxide, Titandioxid, Zinkoxid, Zinndioxide, Zirkondioxid;
Metallsulfide, wie z.B. Cadmiumsulfid, Molybdänsulfid, Quecksilbersulfid, Silbersulfid, Zinksulfid;
Metallsulfate, wie z.B. Bariumsulfat, Calciumsulfat, Cobaltsulfat, Strontiumsulfat; Metallcarbonate, wie z.B. Bariumcarbonat, Bleicarbonat, Calciumcarbonat, Strontiumcarbonat, Zinkcarbonat;
Chromate wie z.B. Bleichromat, Zinkchromat;
sowie Spinelle der allgemeinen Formel AB₂X₄, wobei A ein zweiwertiges Metall wie z.B. Fe(II), Zn, Mn, Co, Ni, Cu, Cd; B ein dreiwertiges Metall wie z.B. Al, Fe(III), V, Cr, Ti, und X die Elemente O, S, Se sein können, wie z.B. Kupferchromoxide, Cobaltaluminiumoxide, Cobaltchromoxide, in Betracht.

Als weitere anorganische Pigmente eignen sich z.B. Bariumtitanat, Berliner Blau, Bismutvanadat, Chromantimontitanoxid, Manganviolett, Molybdänblau, Molybdatrot, Schwefel, Titannitrid, Ultramarin oder Wolframbtau.

Als Metallpartikel kommen beispielsweise Elemente wie
Antimon, Bismut, Blei, Cadmium, Chrom, Cobalt, Eisen, Gold, Indium, Iridium, Kupfer, Magnesium, Mangan, Molybdän, Nickel, Osmium, Palladium, Platin, Rhodium, Ruthenium, Samarium, Selen, Silber, Silicium, Tantal, Titan, Vanadium, Wolfram, Zink, Zinn, Zirkonium oder Legierungen wie Bronze, Messing, Stahl in Betracht.

Besonders bevorzugt ist Graphit und Ruß.

Die Pigmente und Metallpartikel erhält man in der genannten Teilchengröße beispielsweise durch Mahlung und/oder Sieben entsprechender Pigmente, Rohpigmente oder Metallpartikel bis zum gewünschten Feinverteilungsgrad.

Als Bildner der Polymermatrix kommen vorzugsweise Polymere aus der Gruppe der Polyvinylacetate, Polyvinylalkohole, Polyvinylbutyrale, Polyacrylate, Polymethacrylate, Polyepoxide, Polyvinylpyrrolidon, die auch noch entsprechende Oligomere und/oder Monomere enthalten können, in Betracht.
Die Polymermatrix kann noch weitere übliche Kunststoff-Additive, wie z.B. Verlaufsmittel, Weichmacher, bevorzugt Polyalkylenglykole, Vernetzungsinitiatoren, Sensitizer, Antioxidantien und Lösungsmittel, wie z.B. Ketone, Ether, Amide, Alkohole und Wasser, enthalten.

Besonders bevorzugtes Matrixmaterial ist Polyvinylalkohol, gelöst in Wasser.

Die dynamische Viskosität der Polymermatrix liegt vorzugsweise im Bereich zwischen 50 und 1000 mPas, insbesondere zwischen 100 und 500 mPas, gemessen mit einem Rotationsviskosimeter bei 25°C und einer Drehzahl von 200 s⁻¹.

Zur Herstellung der Polymermatrix löst man das Polymer in einem dafür geeigneten Lösungsmittel, wie z.B. Wasser, ein- oder mehrwertige Alkohole, deren Ether und Ester, z.B. Alkanole mit 1 bis 4 C-Atomen, wie z.B. Methanol, Ethanol, Propanol, Isopropanol, Butanol, Isobutanol; zwei- oder dreiwertige Alkohole, insbesondere mit 2 bis 6 C-Atomen, z. B. Ethylenglykol, Propylenglykol, 1,3-Propandiol, 1,4-Butandiol, 1,5-Pentandiol, 1,6-Hexandiol, 1,2,6-Hexantriol, Glyzerin, Diethylenglykol, Dipropylenglykol, Triethylenglykol, Polyethylenglykol, Tripropylenglykol, Polypropylenglykol; niedere Alkylether von mehrwertigen Alkoholen, wie z. B. Ethylenglykolmonomethyl- oder ethyl- oder propyl- oder butylether, Ethylenglykoldimethyl- oder ethyl- oder propyl- oder butylether, Diethylenglycolmonomethyl- oder ethylether, Diethylenglycoldimethyl- oder ethylether, Triethylenglykolmonomethyl- oder -ethylether, Triethylenglykoldimethyloder ethylether, Propylenglycolmonomethyl- oder ethyl- oder propyl- oder butylether, Propylenglycoldimethyl- oder ethyl- oder propyl- oder butylether, Dipropylenglycolmonomethyl- oder ethyl- oder butylether, Dipropylenglycoldimethyl- oder ethyl- oder butylether, cyclische Ether wie Tetrahydrofuran, Dioxolan, Dioxan; Ether wie tert-Butylmethylether, Diethylether; Ketone und Ketonalkohole, wie z. B. Aceton, Methylethylketon, Di-ethylketon, Methylisobutylketon, Methylpentylketon, Cyclopentanon, Cyclohexanon, Diacetonalkohol; Ester, wie z.B. Essigsäuremethyl- oder ethyl- oder propyl- oder butylester, Propansäuremethyl oder ethyl- oder propyl- oder butylester, Butyrolacton, Milchsäuremethyl- oder ethylester; Amide, wie z.B.

Dimethylformamid, Dimethylacetamid und N-Methylpyrrolidon; Aromaten wie Toluol, Xylol; chlorierte Kohlenwasserstoffe wie Chloroform, Methylenchlorid; Acetonitril sowie Gemische davon.

Der Polymerlösung setzt man vorzugsweise einen Weichmacher zu, der die Flexibilität der Maske erhöht und die Schrumpfung der Matrix beim Trocknen verringert, so dass sich keine Hohlräume im getrockneten Matrixmaterial bilden können, die zu unerwünschter Lichtstreuung führen.
Als Weichmacher sind Diethylenglykol und Polyethylenglykole besonders bevorzugt.
Die Pigmentpartikel oder Metallpartikel müssen homogen in der Polymermatrix dispergiert sein. Dazu verwendet man bekannte Dispergierhilfen, wie z.B. Dissolver, Rührer, Kneter und weitere übliche Dispergieraggregate. Außerdem können zusätzliche Lösungsmittel, Netzhilfsmittel, Emulgatoren und Dispergiermittel, wie z.B. anionische, kationische oder nichtionische Tenside, verwendet werden, um Viskosität und Oberflächenspannung der Matrix entsprechend den Erfordernissen der verwendeten Folienbeschichtungstechnik einzustellen.

Die optischen Eigenschaften der Maske (und damit die des daraus herzustellenden Diffusors) kann man über die Partikelgröße des Pigments oder Metalls, über den Volumenanteil des Pigments in der Maske sowie über die Schichtdicke der Polymermatrix einstellen.
Der Volumenanteil des Pigments in der Matrix ist vorzugsweise 0,5 bis 10 Vol.-%, insbesondere 1 bis 5 Vol.-%, bezogen auf das Gesamtvolumen der Matrix einschließlich Pigment bzw. Metallpartikels.
Die Schichtdicke der Polymermatrix ist vorzugsweise 1 bis 20 µm, insbesondere 2 bis 10 µm.

Als Trägerfolie verwendet man Kunststofffolien, die für das zur Herstellung des Diffusors verwendete Licht transparent sein müssen. Bevorzugt sind Folien aus Polyester, Celluloseacetat, Polycarbonat, Polypropylen, Polyethylen und Polymethylmethacrylat. Besonders bevorzugt sind Folien aus Polyethylenterephthalat.
Die Schichtdicke der Trägerfolie ist vorzugsweise 10 bis 200 µm, insbesondere 20 bis 150 µm, besonders bevorzugt 30 bis 100 µm.

Gegenstand der Erfindung ist auch ein Verfahren zur Herstellung einer Kompositmaske, dadurch gekennzeichnet, dass man ein Pigment oder Metallpartikel der genannten Teilchengröße in einer Polymermatrixlösung dispergiert, mit der erhaltenen Mischung eine Trägerfolie beschichtet und anschließend trocknet.
Das Beschichten der Trägerfolie kann mit handelsüblichen Folienbeschichtungsanlagen im Rakelverfahren durchgeführt werden, bevorzugt bei einer Vorschubgeschwindigkeit von 0,5 bis 5 m/min. Die Trocknung wird zweckmäßigerweise bei einer Temperatur von 60 bis 150°C durchgeführt. Gegenstand der Erfindung ist auch die Verwendung einer Kompositmaske zur Herstellung eines Diffusors. Hierzu wird die Kompositmaske an eine Folie aus einem photopolymeren Material laminiert, das photopolymere Material durch die Kompositmaske hindurch mit konvergentem UV/Vis-Licht bestrahlt, um Änderungen des Brechungsindex des photopolymeren Materials zu erzeugen, wodurch dem Fleckmuster der Kompositmaske entsprechende Mikrobereiche mit Brechungsindexgradation ausgebildet werden, die anschließend durch UV-Bestrahlung ausgehärtet werden, und der so entstandene Diffusor von der Kompositmaske wieder delaminiert. Ein derartiges Verfahren ist beispielsweise in der EP-A-0 671 638 beschrieben. Der Diffusor selbst kann zu Displayfolien (passive Lichtleitersysteme; Erhöhung des "viewing angle") und in Architekturglas verwendet werden.

Herstellung einer Polyvinylalkohol-Mischung:
a) Lösen von ®Mowiol 18-88 (Firma Clariant):
   Es wurden 4050 g H₂O _{deion} in einem 5 I Reaktor vorgelegt. Unter Rühren (Propellerrührer, ca. 250 U/min) wurden 450 g Mowiol 18-88 langsam zugegeben. Bei einer Temperierung auf 80°C wurde die Mischung ca. 3 Tage im Reaktor gerührt (Rückflusskühler).
b) Herstellung einer PVA-Mischung:
   Zu 2000 g des PVAs (= 10 % Mowiol 18-88 in Wasser) gemäß a) wurden 200 g Diethylenglykol und anschließend 359 g i-PrOH unter Rühren (Ankerrührer, ca. 250 U/min) zugegeben.

Herstellung einer Graphit-Mischung:
Zu 200 g H₂O _{deion} wurden 1,3 g TWEEN 80 (Emulgator der Firma Merck) unter Rühren (Magnetrührer mit Magnetstab, 300 - 400 U/min) zugegeben. Nach Auflösen des Emulgators erfolgte eine langsame Zugabe von 12,8 g Graphit KS 4 der Firma Timca (12,8 g Graphit in ca. 5,30 min) ebenfalls unter Rühren. Die Mischung wurde anschließend noch weitere 10 min gerührt und dann an einer Ultraschall-Lanze behandelt.

Fertigstellung der Graphit-Polymermatrix:
32,5 g der Graphit-Mischung wurden unter Rühren (Ankerrührer, ca. 250 U/min) zu 225 g der PVA-Mischung gegeben. Als weitere Komponenten wurden nacheinander unter Rühren noch 37,5 g iso-PrOH, 37,5 g EtOH sowie 3,3 g ®Byk 306 zugegeben.

Beschichtungsvorgang:
Die Graphit-Polymermatrix wurde mit einer Folienbeschichtungsanlage (Mathis, 600 mm breit) im Rakelverfahren auf eine handelsübliche Polyesterfolie (Dicke 50 µm) mit einer Vorschubgeschwindigkeit von 2 m/min aufgetragen und bei 120°C (Trocknungszeit 1,5 min) unter Erhalt einer Kompositmaske getrocknet.

Verwendung der Kompositmaske:
Die Kompositmaske wurde auf kommerziell erhältliches Photopolymer, wie z.B. in WO 94/29768 beschrieben, laminiert und in einem Mask-Aligner für 2 min mit UV-Licht (Hg-Lampe mit Kaltlichtspiegel 350 - 450 nm, 2 min, 1860 ft cd) bestrahlt und anschließend für 1 min durch ganzflächige UV-Bestrahlung fixiert. Dabei wurde eine Diffusorfolie ("viewing angle" von 16°) erhalten, die eine sehr gute optische Übereinstimmung im Vergleich zu einer mittels herkömmlichen Photomasken, wie in WO 94/29768 beschrieben, hergestellten Diffuserfolie ("viewing angle" von 19°) aufweist.
Zur Bestimmung des "viewing angles" wird die Diffusorfolie von einer Seite (senkrechte Einfallsrichtung) mit konvergentem Licht beleuchtet, und man mißt die Intensität I des transmittierten Lichtes mit einem Photodetektor als Funktion des Winkels α. Der Winkel α (-90° < = *α* < = 90°) bezeichnet dabei die Abweichung vom Lot. Der "viewing angle" entspricht der Halbwertsbreite I/2. Je größer der "viewing angle" ist, desto höher ist die Streukraft des Materials.

## Patentansprüche

1. Verwendung einer Kompositmaske, bestehend im wesentlichen aus einer transparenten Trägerfolie, die mit einer transparenten Polymermatrix, enthaltend lichtabsorbierende Pigmentteilchen oder Metallpartikel mit einer mittleren Teilchengröße d₅₀ zwischen 0,5 und 10 µm, beschichtet ist, zur Herstellung eines Diffusors, insbesondere für Displayfolien und Architekturglas.

2. Verwendung nach Anspruch 1, **dadurch gekennzeichnet, dass** die Pigmentteilchen oder Metallpartikel eine mittlere Teilchengröße d₅₀ zwischen 1 und 5 µm, bevorzugt zwischen 2 und 4 µm, besitzen.

3. Verwendung nach Anspruch 1 oder 2, **dadurch gekennzeichnet, dass** die Pigmentteilchen organische Pigmente sind.

4. Verwendung nach Anspruch 3, **dadurch gekennzeichnet, dass** das organische Pigment ein Monoazo-, Disazo-, verlacktes Azo-, β-Naphthol-, Naphthol AS-, Benzimidazolon-, Disazokondensations-, Azo-Metallkomplex-Pigment oder ein Phthalocyanin-, Chinacridon-, Perylen-, Perinon-, Thiazinindigo-, Thioindigo-, Anthanthron-, Anthrachinon-, Flavanthron-, Indanthron-, Isoviolanthron-, Pyranthron-, Dioxazin-, Chinophtalon-, Isoindolinon-, Isoindolin- oder Diketopyrrolopyrrol-Pigment, ein Carbon Black-Pigment (Ruß) oder Graphit ist.

5. Verwendung nach Anspruch 1 oder 2, **dadurch gekennzeichnet, dass** die Pigmentteilchen anorganische Pigmente sind.

6. Verwendung nach Anspruch 5, **dadurch gekennzeichnet, dass** das anorganische Pigment ein Antimonoxid-, Bismutoxid-, Bleioxid-, Cadmiumoxid-, Chromoxid-, Cobaltoxid-, Eisenoxid-, Indiumoxid-, Kupferoxid-, Manganoxid-, Nickeloxid-, Quecksilberoxid-, Titandioxid-, Zinkoxid-, Zinndioxid-, Zirkondioxid-, Cadmiumsulfid-, Molybdänsulfid-, Quecksilbersulfid-, Silbersulfid-, Zinksulfid-, Bariumsulfat-, Calciumsulfat-, Cobaltsulfat-, Strontiumsulfat-, Bariumcarbonat-, Bieicarbonat-, Calciumcarbonat-, Strontiumcarbonat-, Zinkcarbonat-, Bleichromat-, Zinkchromat-, Kupferchromoxid-, Cobaltaluminiumoxid-, Cobaltchromoxid-, Bariumtitanat-, Berliner Blau-, Bismutvanadat-, Chromantimontitanoxid-, Manganviolett-, Molybdänblau-, Molybdatrot-, Schwefel-, Titannitrid-, Ultramarinoder Wolframblau-Pigment ist.

7. Verwendung nach Anspruch 1 oder 2, **dadurch gekennzeichnet, dass** die Metallpartikel aus Antimon-, Bismut-, Blei-, Cadmium-, Chrom-, Cobalt-, Eisen-, Gold-, Indium-, Iridium-, Kupfer-, Magnesium-, Mangan-, Molybdän-, Nickel-, Osmium-, Palladium-, Platin-, Rhodium-, Ruthenium-, Samarium-, Selen-, Silber-, Silicium-, Tantal-, Titan-, Vanadium-, Wolfram-, Zink-, Zinn-, Zirkonium-, Bronze-, Messing- oder Stahl-Teilchen bestehen.

8. Verwendung nach mindestens einem der Ansprüche 1 bis 7, **dadurch gekennzeichnet, dass** die Polymermatrix aus Polyvinylacetat, Polyvinylalkohol, Polyvinylbutyral, Polyacrylat, Polymethacrylat, Polyepoxid, Polyvinylpyrrolidon, die auch noch Oligomere und/oder Monomere davon enthalten können, oder einer Mischung davon besteht.

9. Verwendung nach mindestens einem der Ansprüche 1 bis 8, **dadurch gekennzeichnet, dass** die Trägerfolie aus Polyester, Celluloseacetat, Polycarbonat, Polypropylen, Polyethylen oder Polymethylmethacrylat besteht.

10. Verwendung nach mindestens einem der Ansprüche 1 bis 9, **dadurch gekennzeichnet, dass** der Volumenanteil des Pigments oder der Metallpartikel in der Matrix 0,5 bis 10 Vol.-%, bezogen auf das Gesamtvolumen der Matrix einschließlich Pigment oder Metalfpartikel, beträgt.

## Claims

1. Use of a composite mask consisting essentially of a transparent support film which has been coated with a transparent polymer matrix containing light-absorbent pigment particles or metal particles having a mean particle size d₅₀ of between 0.5 and 10 µm, for the production of a diffuser, in particular for display films and architectural glass.

2. Use as claimed in claim 1, wherein the pigment particles or metal particles have a mean particle size d₅₀ of between 1 and 5 µm, preferably between 2 and 4 µm.

3. Use as claimed in claim 1 or 2, wherein the pigment particles are organic pigments.

4. Use as claimed in claim 3, wherein the organic pigment is a monoazo, disazo, laked azo, β-naphthol, naphthol AS, benzimidazolone, disazo condensation, azo metal complex pigment or a phthalocyanine, quinacridone, perylene, perinone, thiazineindigo, thioindigo, anthranone, anthraquinone, flavanthrone, indanthrone, isoviolanthrone, pyranthrone, dioxazine, quinophthalone, isoindolinone, isoindoline or diketopyrrolopyrrole pigment, a carbon black pigment or graphite.

5. Use as claimed in claim 1 or 2, wherein the pigment particles are inorganic pigments.

6. Use as claimed in claim 5, wherein the inorganic pigment is an antimony oxide, bismuth oxide, lead oxide, cadmium oxide, chromium oxide, cobalt oxide, iron oxide, indium oxide, copper oxide, manganese oxide, nickel oxide, mercury oxide, titanium dioxide, zinc oxide, tin dioxide, zirconium dioxide, cadmium sulfide, molybdenum sulfide, mercury sulfide, silver sulfide, zinc sulfide, barium sulfate, calcium sulfate, cobalt sulfate, strontium sulfate, barium carbonate, lead carbonate, calcium carbonate, strontium carbonate, zinc carbonate, lead chromate, zinc chromate, copper chromium oxide, cobalt aluminum oxide, cobalt chromium oxide, barium titanate, Berlin Blue, bismuth vanadate, chromium antimony titanium oxide, Manganese Violet, Molybdenum Blue, Molybdate Red, sulfur, titanium nitride, ultramarine or Tungsten Blue pigment.

7. Use as claimed in claim 1 or 2, wherein the metal particles consist of antimony, bismuth, lead, cadmium, chromium, cobalt, iron, gold, indium, iridium, copper, magnesium, manganese, molybdenum, nickel, osmium, palladium, platinum, rhodium, ruthenium, samarium, selenium, silver, silicon, tantalum, titanium, vanadium, tungsten, zinc, tin, zirconium, bronze, brass or steel particles.

8. Use as claimed in at least one of claims 1 to 7, wherein the polymer matrix consists of polyvinyl acetate, polyvinyl alcohol, polyvinylbutyral, polyacrylate, polymethacrylate, polyepoxide, polyvinylpyrrolidone, which may also contain oligomers and/or monomers thereof, or a mixture thereof.

9. Use as claimed in at least one of claims 1 to 8, wherein the support film consists of polyester, cellulose acetate, polycarbonate, polypropylene, polyethylene or polymethyl methacrylate.

10. Use as claimed in at least one of claims 1 to 9, wherein the proportion by volume of the pigment or metal particles in the matrix is from 0.5 to 10% by volume, based on the total volume of the matrix, including pigment or metal particles.

## Revendications

1. Utilisation d'un masque de composite constitué essentiellement par une feuille de support transparente, qui est revêtue d'une matrice polymère transparente renfermant des particules pigmentaires ou des particules métalliques absorbant la lumière présentant une taille moyenne de particules d₅₀ comprise entre 0,5 et 10 µm, pour la préparation d'un diffuseur, en particulier des feuilles d'afficheurs et de verre de construction.

2. Utilisation selon la revendication 1, **caractérisée en ce que** les particules pigmentaires ou les particules métalliques présentent une taille moyenne de particules d₅₀ comprise entre 1 et 5 µm, de préférence entre 2 et 4 µm.

3. Utilisation selon la revendication 1 ou 2, **caractérisée en ce que** les particules pigmentaires sont des pigments organiques.

4. Utilisation selon la revendication 3, **caractérisée en ce que** le pigment organique est un pigment monoazoïque, disazoïque, un pigment azoïque laqué, un pigment β-naphtolique, AS-naphtolique, benzimidazolonique, disazoïque de condensation, azoïque-complexe métallique, ou un pigment phtalocyaninique, quinacridonique, pérylénique, périnonique, thiazoindigoïde, anthanthronique, anthraquinonique, flavanthronique, indanthronique, isoviolanthronique, pyranthronique, dioxazinique, quinophtalonique, isoindolinonique, isoindolique ou dicétopyrrolo-pyrrolique, un pigment de noir de carbone (noir de fumée) ou le graphite.

5. Utilisation selon la revendication 1 ou 2, **caractérisée en ce que** les particules pigmentaires sont des pigments inorganiques.

6. Utilisation selon la revendication 5, **caractérisée en ce que** le pigment inorganique est un pigment à base d'oxyde d'antimoine, d'oxyde de bismuth, d'oxyde de plomb, d'oxyde de cadmium, d'oxyde de chrome, d'oxyde de cobalt, d'oxyde de fer, d'oxyde d'indium, d'oxyde de cuivre, d'oxyde de manganèse, d'oxyde de nickel, d'oxyde de mercure, de dioxyde de titane, d'oxyde de zinc, de dioxyde d'étain, de dioxyde de zirconium, de sulfure de cadmium, de sulfure de molybdène, de sulfure de mercure, de sulfure d'argent, de sulfure de zinc, de sulfate de baryum, de sulfate de calcium, de sulfate de cobalt, de sulfate de strontium, de carbonate de baryum, de carbonate de plomb, de carbonate de calcium, de carbonate de strontium, de carbonate de zinc, de chromate de plomb, de chromate de zinc, de chromoxyde de cuivre, d'oxyde de cobalt-aluminiuum, de chromoxyde de cobalt, de titanate de baryum, de bleu de Prusse, de vanadate de bismuth, d'oxyde de chrome-antimoine-titane, de violet de manganèse, de bleu de molybdène, de rouge de molybdate, de soufre, de nitrure de titane, d'ultramarine et de bleu de tungstène.

7. Utilisation selon la revendication 1 ou 2, **caractérisée en ce que** les particules métalliques sont des particules d'antimoine, de bismuth, de plomb, de cadmium, de chrome, de cobalt, de fer, d'or, d'indium, d'iridium, de cuivre, de magnésium, de manganèse, de molybdène, de nickel, d'osmium, de palladium, de platine, de rhodium, de ruthénium, de samarium, de sélène, d'argent, de silicium, de tantale, de titane, de vanadium, de tungstène, de zinc, d'étain, de zirconium, de bronze, de laiton ou d'acier.

8. Utilisation selon au moins l'une des revendications 1 à 7, **caractérisée en ce que** la matrice polymère est en poly(acétate de vinyle), poly(alcool de vinyle), poly(butyral de vinyle), polyacrylate, polyméthacrylate, polyépoxyde, polyvinylpyrrolidone, qui peut également renfermer encore leurs oligomères et/ou monomères, ou un mélange de ces matières.

9. Utilisation selon au moins l'une des revendications 1 à 8, **caractérisée en ce que** la feuille de support est en polyester, acétate de cellulose, polycarbonate, polypropylène, polyéthylène ou poly(méthacrylate de méthyle).

10. Utilisation selon au moins l'une des revendications 1 à 9, **caractérisée en ce que** le taux volumique du pigment ou des particules métalliques dans la matrice est de 0,5 à 10 % vol., par rapport au volume total de la matrice y compris le pigment ou les particules métalliques.
